# EUROPEAN PATENT SPECIFICATION

(11) **EP 4 418 482 B1**
(45) Date of publication and mention of the grant of the patent: **07.10.2026**
(21) Application number: 22952944.1
(22) Date of filing: 28.12.2022
(51) Int. Cl.: H02H 3/28, H02H 3/16, H02H 3/38, H02H 7/26, G01R 31/08

(54) **ZERO-SEQUENCE RESISTIVE CURRENT DIFFERENTIAL PROTECTION METHOD FOR INTER-STATION TIE LINE OF SMALL-RESISTANCE GROUNDING SYSTEM**
NULLSEQUENZ-WIDERSTANDSSTROMDIFFERENZSCHUTZVERFAHREN FÜR ZWISCHENSTATIONS-VERKNÜPFUNGSLEITUNG EINES ERDUNGSSYSTEMS MIT GERINGEM WIDERSTAND
PROCÉDÉ DE PROTECTION DIFFÉRENTIELLE DE COURANT RÉSISTIF À SÉQUENCE NULLE POUR LIGNE DE LIAISON INTER-CENTRALE D'UN SYSTÈME DE MISE À LA TERRE À FAIBLE RÉSISTANCE

(30) Priority: 26.07.2022 CN 202210886960
(43) Date of publication of application: 21.08.2024
(73) Proprietor: Xi'an Thermal Power Research Institute Co., Ltd., Xi'an, Shaanxi 710032 (CN)
(72) Inventor: HE, Xinlin, Xi'an, Shaanxi 710032 (CN); WU, Hao, Xi'an, Shaanxi 710032 (CN); LI, Yi, Xi'an, Shaanxi 710032 (CN); GUO, Lin, Xi'an, Shaanxi 710032 (CN); YANG, Zhilong, Xi'an, Shaanxi 710032 (CN); WANG, Chuangbo, Xi'an, Shaanxi 710032 (CN); LIU, Xuhui, Xi'an, Shaanxi 710032 (CN); LI, Chunli, Xi'an, Shaanxi 710032 (CN); LEI, Yang, Xi'an, Shaanxi 710032 (CN); ZHANG, Peng, Xi'an, Shaanxi 710032 (CN); FANG, Zichao, Xi'an, Shaanxi 710032 (CN); NI, Jiwen, Xi'an, Shaanxi 710032 (CN)
(74) Representative: Groth & Co. KB
(86) International application number: PCT/CN2022/142779
(87) International publication number: WO 2024/021515

(56) References cited:
- WO-A2-01/78209
- CN-A- 107 317 312
- CN-A- 107 317 312
- CN-A- 108 776 284
- CN-A- 112 436 492
- CN-A- 113 241 739
- CN-A- 115 224 676
- US-A1- 2013 035 882
- US-A1- 2019 137 556
- RAJIC TOMISLAV ET AL: "Zero-sequence longitudinal differential protection of transmission lines", ELECTRICAL ENGINEERING, SPRINGER, BERLIN, DE, vol. 102, no. 2, 2 January 2020 (2020-01-02), pages 747 - 762, XP037141706, ISSN: 0948-7921, [retrieved on 20200102], DOI: 10.1007/S00202-019-00908-4
- GAJIC ZORAN ET AL: "Restricted Earth-Fault (REF) Protection Challenges due to Extensive Use of Cables: A Case Study", 2021 74TH CONFERENCE FOR PROTECTIVE RELAY ENGINEERS (CPRE), IEEE, 22 March 2021 (2021-03-22), pages 1 - 6, XP033915268, DOI: 10.1109/CPRE48231.2021.9429845

## Description

### CROSS REFERENCE TO RELATED APPLICATIONS

The present application claims priority to Chinese Patent Application No. 202210886960.7, filed to the CNIPA on July 26, 2022, and entitled "Zero-sequence Resistive-current Differential Protection Method for Inter-station Tie Line of Low-resistance Grounding System".

### TECHNICAL FIELD

The present application belongs to the technical field of power system relay protection, and relates to a zero-sequence resistive-current differential protection method for an inter-station tie line of a low-resistance grounding system.

### BACKGROUND

As new energy sources continue to scale up, there are more and more dispersedly distributed wind power stations, photovoltaic power stations and energy storage power stations. After being connected by a tie line, multiple power stations are connected to the power grid through one power station.

At present, the single-phase grounding protection for a tie line adopts full-current zero-sequence differential protection. When an external single-phase grounding fault occurs in the tie line, the differential current between the two sides of the tie line contains the grounding capacitance current of the tie line, which is not conducive to the selectivity of single-phase differential protection and reduces the protection reliability. When an internal single-phase grounding fault occurs in the tie line, the differential current of the grounding capacitance currents of the tie line at two sides of the line is close to zero, which does not increase the differential action current. At the same time, the amplitude of the capacitive differential current depends on the grounding capacitance currents of the power stations on two sides, that is, the amplitude of the capacitive differential current is affected by the operating mode of the power station.

For resistance-grounded power stations, the single-phase grounding protection for the tie line adopts resistive-current zero-sequence differential protection. when the ground resistances on two sides of the tie line are effectively enabled, the disadvantageous factors of the capacitance current during the single-phase grounding may be overcome, and the tie line is affected neither by the large unbalanced current at the external fault due to the excessive length of the tie line, nor by the operating mode of the power station. With resistive current zero-sequence differential protection, the zero-sequence differential current is the difference of vectors of resistive currents flowing through the current transformers on two sides of the tie line when single-phase grounding occurs in the tie line. The present application utilises the characteristics of the zero-sequence current of the tie line and adopts the relay protection method based on the principle of resistive-current zero-sequence differential protection to accurately judge whether single-phase grounding occurs in the grounded tie line in time and cut out faulty tie line. The present application is clear and reliable in principle, and conforms to the basic principles of relay protection, namely, reliability, sensitivity, selectivity and speed.

US 2013/0035882 A1 discloses a method and apparatus for differential protection of a three phase electric connection of an electric system. US 2013/0035882 A1 discloses that the apparatus includes means for determining a value of an operate quantity, which operate quantity is based on a difference between current quantities at a first point and a second point of the electric connection, and means for detecting a fault in the electric connection between the first point and the second point if the value of the operate quantity exceeds a value of a predetermined threshold quantity. US 2013/0035882 A1 further discloses that the operate quantity is based on a difference of residual currents at the first point and the second point, or a quantity indicative thereof, and a coefficient indicative of an angle between a residual voltage of the electric connection and the difference of residual currents at the first point and the second point.

T. Rajic et al., "Zero-sequence longitudinal differential protection of transmission lines", Electrical Engineering (2020) 102:747-762, discloses an earth fault-sensitive algorithm for the longitudinal differential protection of transmission lines. According to the abstract of this reference, the sensitivity of longitudinal differential protection in radial networks was examined, problems which can influence the protection's speed and reliability were considered, such as great line length and the presence of resistance at fault position, and the algorithm was tested for isolated and low-impedance earthed networks.

WO 01/78209 A2 discloses a line current differential protective relay and method for protecting transmission lines with power transformers tapped between the substations without any measurements taken at the tap point. WO 01/78209 A2 discloses that the protection method uses distance supervision by an overreaching instantaneous impedance zone to prevent malfunction of the relay during external faults at the distribution busbar of the tapped transformer, and further that the protection method uses a modified current differential principle that compares the zero sequence compensated differential and restraining signals to ensure relay stability on external ground faults. WO 01/78209 A2 further discloses that the protection method combines both the traditional and modified current differential principles to ensure phase-selective operation.

Z. Gajic et al., "Restricted Earth-Fault (REF) Protection Challenges due to Extensive Use of Cables: A Case Study", 2021 74TH CONFERENCE FOR PROTECTIVE RELAY ENGINEERS (CPRE), IEEE, 22 March 2021, pages 1-6, discloses, according to the abstract of this reference, that capacitive zero-sequence currents do exist in any power system during an earth-fault regardless network grounding principle, but that existence of these currents is typically ignored in traditional protection practice.

CN107317312A discloses, according to an English machine translation of its abstract, a grounding mode self-recognition power distribution network line differential protection device. According to the said English machine translation, the device comprises a collecting circuit, a calculating circuit, a judging circuit and a zero-sequence differential protection circuit, wherein the collecting circuit is used for collecting the electric quantity characteristics of a current power distribution network line respectively, wherein the electric quantity characteristics comprise zero-sequence voltage, own-side zero-sequence current and opposite-side zero-sequence current; the calculating circuit is used for calculating the zero-sequence differential current of the current power distribution network line; the judging circuit is used for judging whether the grounding mode is a neutral low-resistance grounding mode; the zero-sequence differential protection circuit is used for starting zero-sequence differential protection and outputting a control signal so as to control the switching-on and switching-off of the switch of the current power distribution network line when the grounding mode of the current power distribution network line is the neutral low-resistance grounding mode.

### SUMMARY

The object of the present application is to overcome the above-mentioned shortcomings of the prior art, and provide a zero-sequence resistive-current differential protection method for an inter-station tie line of a low-resistance grounding system, which is capable of accurately judging whether single-phase grounding occurs in the grounded tie line in time and cutting the out faulty tie line.

In order to achieve the above object, the zero-sequence resistive-current differential protection method for an inter-station tie line of a low-resistance grounding system according to the present application includes the following steps:
1) acquiring three-phase currents 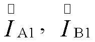 and 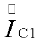 of a three-phase current transformer at a sending end of the tie line, acquiring a zero-sequence voltage 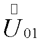 of a bus of a power station at the sending end of the tie line, acquiring three-phase currents 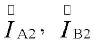 and 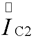 of a three-phase current transformer at a receiving end of the tie line, and acquiring a zero-sequence voltage 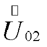 of a bus of a power station at the receiving end of the tie line;
2) calculating a resistive zero-sequence current 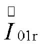 at the sending end of the tie line according to the three-phase currents 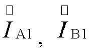 and 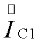 of the three-phase current transformer at the sending end of the tie line, and 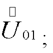
3) calculating a resistive zero-sequence current 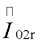 at the receiving end of the tie line according to the three-phase currents 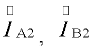 and 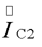 of the three-phase current transformer at the receiving end of the tie line, and 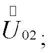
4) calculating a zero-sequence resistive differential current 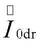 according to the resistive zero-sequence current 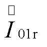 at the sending end of the tie line and the resistive zero-sequence current 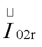 at the receiving end of the tie line; and
5) performing a zero-sequence differential protection action when 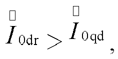 wherein 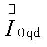 is a zero-sequence differential starting current, and 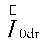 is zero-sequence resistive differential current;

The zero-sequence resistive differential current 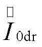 is: 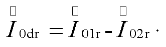 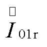 is resistive zero-sequence current at the sending end of the tie line, 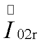 is resistive zero-sequence current at the receiving end of the tie line;

The resistive zero-sequence current 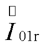 at the sending end of the tie line is: 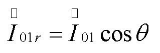 wherein *θ* is an included angle between 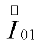 and 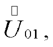 and 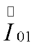 is a three-phase current vector at the sending end of the tie line.

The three-phase current vector 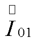 at the sending end of the tie line is:

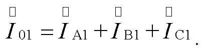

The resistive zero-sequence current 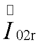 at the receiving end of the tie line is: 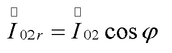 wherein *φ* is an included angle between 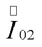 and 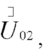 and 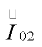 is a three-phase current vector at the receiving end of the tie line.

The three-phase current vector 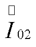 at the receiving end of the tie line is:

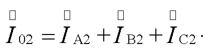

The present application has the following beneficial effects:
when the zero-sequence resistive-current differential protection method for an inter-station tie line of a low-resistance grounding system provided by the present application is specifically operated, the zero-sequence resistive differential current 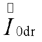 is calculated, whether a single-phase grounding fault occurs is judged according to the zero-sequence resistive differential current 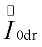 and when it is determined that a single-phase grounding fault occurs, the fault is cut off in time, and when the ground resistances on two sides of the tie line are effectively enabled, the disadvantageous factors of the capacitance current during the single-phase grounding may be overcome, and the tie line is affected neither by the large unbalanced current at the external fault due to the excessive length of the tie line, nor by the operating mode of the power station. With resistive current zero-sequence differential protection, the zero-sequence differential current is the difference of vectors of resistive currents flowing through the current transformers on two sides of the tie line when single-phase grounding occurs in the tie line. The present application utilises the characteristics of the zero-sequence current of the tie line and adopts the relay protection method based on the principle of resistive-current zero-sequence differential protection to accurately judge whether single-phase grounding occurs in the grounded tie line in time and cut out faulty tie line. The present application is clear and reliable in principle, and conforms to the basic principles of relay protection, namely, reliability, sensitivity, selectivity and speed.

### BRIEF DESCRIPTION OF THE DRAWINGS

Fig. 1 is a schematic diagram of a single-phase grounding fault current of a resistance grounded inter-station tie line according to an embodiment of the present application; and
Fig. 2 is a vector diagram according to an embodiment of the present application.

### DETAILED DESCRIPTION

In order to make those skilled in the art better understand the solutions of the present application, the technical solutions in the embodiments of the present application will be clearly and completely described below in conjunction with the drawings in the embodiments of the present application. Obviously, the described embodiments are only part of, but not all of, the embodiments of the present application, and not intended to limit the scope of the disclosure of the present application. Additionally, in the following description, descriptions of well-known structures and techniques are omitted to avoid unnecessarily obscuring the concepts disclosed in the present application.

Structural schematic diagrams according to embodiments disclosed in the present application are shown in the accompanying drawings. The figures are not drawn to scale, with some details exaggerated and some other details omitted for the purpose of clear expression. The shapes of the various regions and layers and their relative sizes and positional relationships shown in the figures are merely exemplary, and deviations may occur in practice due to manufacturing tolerances or technical limitations, and those skilled in the art may otherwise design regions/layers having different shapes, sizes and relative positions according to actual needs.

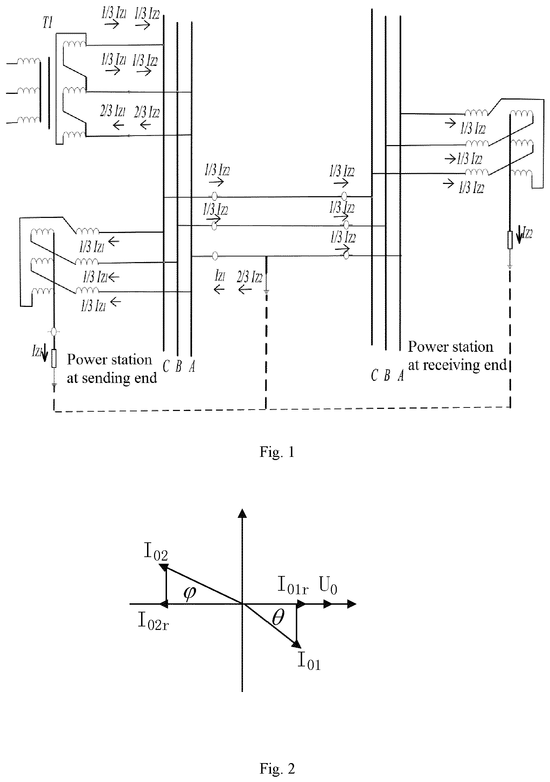

Referring to Fig. 1 and Fig. 2, a zero-sequence resistive-current differential protection method for an inter-station tie line of a low-resistance grounding system in an embodiment of the present application includes the following steps:
1) acquiring three-phase currents 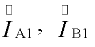 and 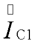 of a three-phase current transformer at a sending end of the tie line, acquiring a zero-sequence voltage 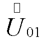 of a bus of a power station at the sending 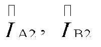 end of the tie line, acquiring three-phase currents and 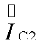 of a three-phase current transformer at a receiving end of the tie line, and acquiring a zero-sequence voltage 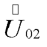 of a bus of a power station at the receiving end of the tie line;
2) calculating a resistive zero-sequence current 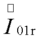 at the sending end of the tie line according to the three-phase currents 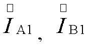 and 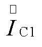 of the three-phase current transformer at the sending end of the tie line, and 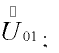 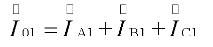 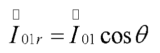 wherein *θ* is an included angle between 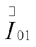 and 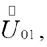 and 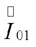 is a three-phase current vector at the sending end of the tie line;
3) calculating a resistive zero-sequence current 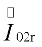 at the receiving end of the tie line according to the three-phase currents 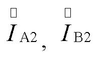 and 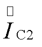 of the three-phase current transformer at the receiving end of the tie line, and 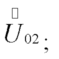 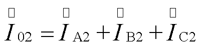 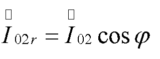 wherein *φ* is an included angle between 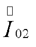 and 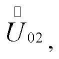 and 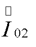 is a three-phase current vector at the receiving end of the tie line;
4) calculating a zero-sequence resistive differential current 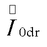 according to the resistive zero-sequence current 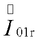 at the sending end of the tie line and the resistive zero-sequence current 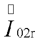 at the receiving end of the tie line 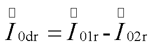
5) performing a zero-sequence differential protection action when 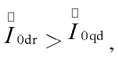 wherein 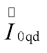 is a zero-sequence differential starting current.

Conditions of the zero-sequence differential protection action further include:
a hard strap of zero-sequence resistive-current differential protection for the tie line is enabled;
a soft strap of zero-sequence resistive-current differential protection for the tie line is enabled;
the grounding transformer circuit breaker of the power station at the sending end of the tie line is in a closed position;
the grounding transformer circuit breaker of the power station at the receiving end of the tie line is in a closed position;
the exit delay of zero-sequence differential protection of the grounding transformer is 0.1 s to 20 s, wherein the specific set value is less than the backup setting time of a neutral zero-sequence overcurrent system.

The present application is applicable to the situation that the single-phase grounding protection for the tie line adopts the resistive current zero-sequence differential protection, and the single-phase grounding protection for the tie line is realized by modifying the protection logic and calculating the differential current. The fault location of the application is accurate, the delay is short, the single-phase grounding is prevented from evolving to phase-to-phase faults, the fault circuit is removed, and the single-phase grounding is effectively prevented from evolving to phase-to-phase faults. The present application is simple and reliable in principle, and conforms to the basic principles of relay protection, namely, reliability, sensitivity, selectivity and speed.

## Claims

1. **A zero-sequence** resistive-current differential protection method for an inter-station tie line of a low-resistance grounding system, comprising the following steps:
1) acquiring three-phase currents 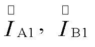 and 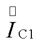 of a three-phase current transformer at a sending end of the tie line, acquiring a zero-sequence voltage 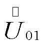 of a bus of a power station at the sending end of the tie line, acquiring three-phase currents 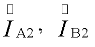 and 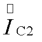 of a three-phase current transformer at a receiving end of the tie line, and acquiring a zero-sequence voltage 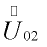 of a bus of a power station at the receiving end of the tie line;
2) calculating a resistive zero-sequence current 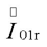 at the sending end of the tie line according to the three-phase currents 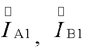 and 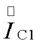 of the three-phase current transformer at the sending end of the tie line, and 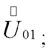
3) calculating a resistive zero-sequence current 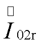 at the receiving end of the tie line according to the three-phase currents 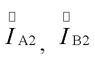 and 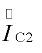 of the three-phase current transformer at the receiving end of the tie line, and 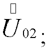
4) calculating a zero-sequence resistive differential current 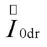 according to the resistive 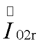 zero-sequence current 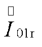 at the sending end of the tie line and the resistive zero-sequence current at the receiving end of the tie line; and
5) performing a zero-sequence differential protection action in response to a condition that 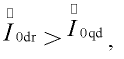 wherein 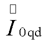 is a zero-sequence differential starting current, and 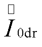 is zero-sequence resistive differential current;
the zero-sequence resistive differential current 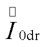 is calculated as: 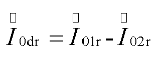 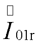
is resistive zero-sequence current at the sending end of the tie line, 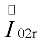 is resistive zero-sequence current at the receiving end of the tie line;
**characterized in that** the resistive zero-sequence current 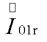 at the sending end of the tie line is: 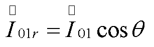 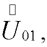
wherein *θ* is an included angle between 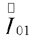 and and 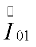 is a three-phase current vector at the sending end of the tie line;
the three-phase current vector 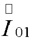 at the sending end of the tie line is a residual zero-sequence current phasor defined as: 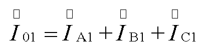
the resistive zero-sequence current 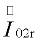 at the receiving end of the tie line is: 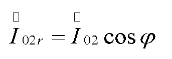 wherein *φ* is an included angle between 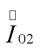 and 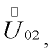 and 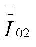 is a three-phase current vector at the receiving end of the tie line;
the three-phase current vector 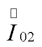 at the receiving end of the tie line is a residual zero-sequence current phasor defined as:

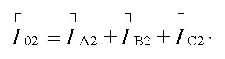

## Patentansprüche

1. Nullsequenz-Widerstandsstromdifferenzschutzverfahren für eine Zwischenstations-Verknüpfungsleitung eines Erdungssystems mit geringem Widerstand, umfassend die folgenden Schritte:
1) Erfassen der Dreiphasenströme *İ*_{*A*1}*_{,} İ*_{*B*1} und *İ*_{*C*1} eines dreiphasigen Stromwandlers am sendeseitigen Ende der Verknüpfungsleitung, Erfassen einer Nullsequenzspannung *U̇*₀₁ an einer Sammelschiene eines Kraftwerks am sendeseitigen Ende der Verknüpfungsleitung, Erfassen der Dreiphasenströme *İ*_{*A*2}*, İ_{B2}* und *İ*_{*C*2} eines dreiphasigen Stromwandlers am empfangsseitigen Ende der Verknüpfungsleitung und Erfassen einer Nullsequenzspannung *U̇*₀₂ an einer Sammelschiene eines Kraftwerks am empfangsseitigen Ende der Verknüpfungsleitung;
2) Berechnen eines resistiven Nullsequenzstroms *İ*_{01*r*} am sendeseitigen Ende der Verknüpfungsleitung auf Grundlage der Dreiphasenströme *İ*_{*A*1}, *İ*_{*B*1} und *İ*_{*C*1} des dreiphasigen Stromwandlers am sendeseitigen Ende der Verknüpfungsleitung und der Nullsequenzspannung *U̇*₀₁;
3) Berechnen eines resistiven Nullsequenzstroms *İ*_{02*r*} am empfangsseitigen Ende der Verknüpfungsleitung auf Grundlage der Dreiphasenströme *İ*_{*A*2}, *İ*_{*B*2} und *İ*_{*C*2} des dreiphasigen Stromwandlers am empfangsseitigen Ende der Verknüpfungsleitung und der Nullsequenzspannung *U̇*₀₂;
4) Berechnen eines resistiven Nullsequenz-Differenzstroms *İ*_{0*dr*} auf Grundlage des resistiven Nullsequenzstroms *İ*_{01*r*} am sendeseitigen Ende der Verknüpfungsleitung und des resistiven Nullsequenzstroms *İ*_{02*r*} am empfangsseitigen Ende der Verknüpfungsleitung; und
5) Auslösen einer Nullsequenz-Differenzschutzaktion, wenn die Bedingung *İ*₀*_{dr} > İ*_{0*qd*} erfüllt ist, wobei *İ*_{0*qd*} ein Ansprechstrom des Nullsequenz-Differenzschutzes ist und *İ*_{0*dr*} der resistive Nullsequenz-Differenzstrom ist;
wobei der resistive Nullsequenz-Differenzstrom *İ*_{0*dr*} wie folgt berechnet wird: ${\dot{I}}_{0 dr} = {\dot{I}}_{01 r} - {\dot{I}}_{02 r} ,$
wobei *İ*_{01*r*} der resistive Nullsequenzstrom am sendeseitigen Ende der Verknüpfungsleitung ist und *İ*_{02*r*} der resistive Nullsequenzstrom am empfangsseitigen Ende der Verknüpfungsleitung ist;
**dadurch gekennzeichnet, dass** der resistive Nullsequenzstrom *İ*_{01*r*} am sendeseitigen Ende der Verknüpfungsleitung wie folgt bestimmt wird: ${\dot{I}}_{01 r} = {\dot{I}}_{01 r} cosθ ,$
wobei *θ* der zwischen *İ*₀₁ und *U̇*₀₁ eingeschlossene Winkel ist und *İ*₀₁ ein Dreiphasenstromvektor am sendeseitigen Ende der Verknüpfungsleitung ist;
dass der Dreiphasenstromvektor *İ*₀₁ am sendeseitigen Ende der Verknüpfungsleitung ein Reststromzeiger des Nullsystems ist, der wie folgt definiert ist: ${\dot{I}}_{01} = {\dot{I}}_{A 1} + {\dot{I}}_{B 1} + {\dot{I}}_{C 1} ,$
dass der resistive Nullsequenzstrom *İ*_{02*r*} am empfangsseitigen Ende der Verknüpfungsleitung wie folgt bestimmt wird: ${\dot{I}}_{02 r} = {i}_{02} cos φ ,$
wobei *φ* der zwischen *İ*₀₂ und *U̇*₀₂ eingeschlossene Winkel ist und *İ*₀₂ ein Dreiphasenstromvektor am empfangsseitigen Ende der Verknüpfungsleitung ist; und
dass der Dreiphasenstromvektor *İ*₀₂ am empfangsseitigen Ende der Verknüpfungsleitung ein Reststromzeiger des Nullsystems ist, der wie folgt definiert ist: ${\dot{I}}_{02} = {\dot{I}}_{A 2} + {\dot{I}}_{B 2} + {\dot{I}}_{C 2} ,$

## Revendications

1. Un procédé de protection différentielle résistive de courant résistif de séquence nulle pour une ligne de connexion inter-stations pour :
1) acquérir des courants triphasés 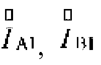 et 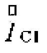 d'un transformateur de courant triphasé à l'extrémité émettrice de la ligne de connexion, acquérir une tension de séquence nulle 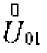 d'un bus d'une centrale électrique à l'extrémité d'envoi de la ligne de connexion, acquérir des courants triphasés 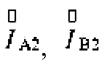 et 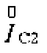 d'un transformateur de courant triphasé à l'extrémité de réception de la ligne de connexion, et acquérir une tension 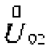 de séquence nulle d'un bus d'une centrale électrique à l'extrémité de réception de la ligne de connexion ;
2) calculer un courant résistif de séquence nulle 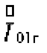 à l'extrémité d'envoi de la ligne de connexion selon les courants triphasés 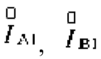 et 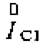 du transformateur de courant triphasé à l'extrémité d'envoi de la ligne de connexion, et 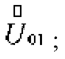
3) calculer un courant résistif de séquence nulle 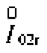 à l'extrémité de réception de la ligne de connexion selon les courants triphasés 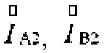 et 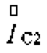 du transformateur de courant triphasé à l'extrémité de réception de la ligne de connexion, et 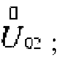
4) calculer un courant différentiel résistif de séquence nulle 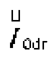 selon le courant résistif de séquence nulle 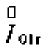 à l'extrémité d'envoi de la ligne de connexion et le courant résistif de séquence 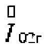 nulle à l'extrémité de réception de la ligne de connexion ; et
5) effectuer une action de protection différentielle de séquence nulle en réponse à une condition dans laquelle 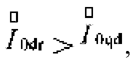 où 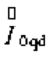 est un courant de départ différentiel de séquence nulle, et 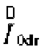 est un courant différentiel résistif de séquence nulle ;
le courant différentiel résistif de séquence nulle 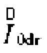 est calculé comme : 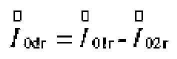 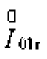
est le courant résistif de séquence nulle à l'extrémité d'envoi de la ligne de connexion, 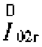 est le courant résistif de séquence nulle à l'extrémité de réception de la ligne de connexion ;
**caractérisé en ce que** le courant résistif de séquence nulle 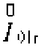 à l'extrémité émettrice de la ligne de connexion est : 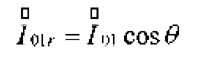
où θ est un angle inclus entre 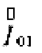 et 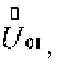 et 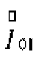 est un vecteur de courant triphasé à l'extrémité d'envoi de la ligne de connexion ;
le vecteur de courant triphasé 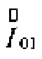 à l'extrémité d'envoi de la ligne de connexion est un phaseur de courant résiduel de séquence nulle défini comme : 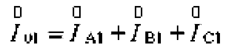
le courant résistif de séquence nulle 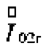 à l'extrémité de réception de la ligne de connexion est : 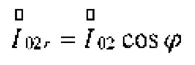
où φ est un angle inclus entre 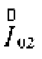 et 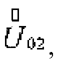 et 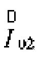 est un vecteur de courant triphasé à l'extrémité de réception de la ligne de connexion ;
le vecteur de courant triphasé à l'extrémité de réception de la ligne de connexion est un 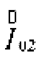 phaseur de courant résiduel de séquence nulle défini comme :
